# EUROPÄISCHE PATENTSCHRIFT

(11) **EP 2 720 298 B1**
(45) Veröffentlichungstag und Bekanntmachung des Hinweises auf die Patenterteilung: **07.12.2016**
(21) Anmeldenummer: 12188364.9
(22) Anmeldetag: 12.10.2012
(51) Int. Cl.: H01M 2/20, H01M 10/48, H01R 31/08, G01R 31/36

(54) **Zellverbinder für ein Batteriesystem**
Cell connector for a battery system
Connecteur de cellules pour un système de batterie

(43) Veröffentlichungstag der Anmeldung: 16.04.2014
(73) Patentinhaber: Samsung SDI Co., Ltd., Yongin-si, Gyeonggi-do (KR)
(72) Erfinder: Fauland, David, 8522 Groß St. Florian (AT)
(74) Vertreter: Gulde & Partner

(56) Entgegenhaltungen:
- JP-A- 2011 049 047
- US-A- 5 788 539
- US-A1- 2011 045 329
- US-A1- 2011 117 769
- US-A1- 2012 015 550

## Beschreibung

### Gebiet der Erfindung

Zellverbinder für ein Batteriesystem das mehrere Batteriezellen umfasst, wobei durch den Zellverbinder ein Pol einer Batteriezelle mit einem Pol einer angrenzenden Batteriezelle elektrisch leitend verbindbar ist.

### Stand der Technik

Derartige Vorrichtungen werden zum Verbinden von Polen benachbarter Batteriezellen verwendet. Die Batteriezellen sind dabei beispielsweise so angeordnet, dass ein positiver Pol und ein negativer Pol einer angrenzenden Batteriezelle einander gegenüberliegend angeordnet sind.

Die Zellverbinder dienen in erster Linie zum elektrischen Verbinden der Batteriezellen. Durch ihre Lage eignen sie sich zum Befestigen von Zellspannungsabgriffen. An den Zellspannungsabgriffen können Mess-Leitungen befestigt werden, die in weiterer Folge zu einer Elektronikeinheit führen. Die Elektronikeinheit dient zur Überwachung der Batteriezellen und erfasst beispielsweise den Ladezustand oder auch die Temperatur der einzelnen Batteriezellen.

Die Pole der Batteriezellen sind beispielsweise aus Aluminium bzw. einer Aluminiumlegierung hergestellt. Die Pole können aber auch aus einem anderen Werkstoff hergestellt sein, wie beispielsweise Kupfer oder Stahl. Es sind auch Mischbauformen, mit einem Pol aus Kupfer und einem Pol aus Aluminium im Stand der Technik bekannt. Mess-Leitungen werden aus Kosten- und Herstellungsgründen zumeist aus Kupfer gefertigt und sind mit einer elektrisch isolierenden Schicht überzogen.

Aus der DE102009033044A1 ist eine Stromzuführeinheit bekannt, welche eine Vielzahl von Sammelschienen, die jeweils ein Paar von Verbindungsteilen, die jeweils mit den angrenzenden Elektroden der angrenzenden Batterien verbunden sind, sowie einen Kopplungsteil aufweisen, der die paarigen Verbindungsteile miteinander koppelt, einen Vielzahl von Klemmelementen, mit denen die Elektroden und die Verbindungsteile festgeklemmt werden, um die Elektroden elektrisch mit den Verbindungsteilen zu verbinden, und eine Platte enthält, an der die Sammelschienen und die Klemmelemente angebracht sind.

Nachteilig bei dieser Ausführung ist der aufwendige Aufbau der Klemmenelemente, welche durch Klemmen oder Aufpressen mit den Elektroden von Batteriezellen verbunden werden, wobei die elektrischen Drähte integral mit den Klemmelementen verbunden sind.

Aus der JP 2011 049047 A ist ein Zellverbinder für ein Batteriesystem bekannt, wobei am Zellverbinder zum Abgriff von elektrischer Spannung eine Schneidklemme ausgebildet ist, zum Einführen einer Messleitung. Ähnliche Zellverbinder, die Schneidklemmen zum Einführen von Messleitungen verwenden, sind auch aus US 2012/015550 A1 und US 2011/045329 A1 bekannt.

Es ist eine Aufgabe der Erfindung einen verbesserten Zellverbinder und ein verbessertes Batteriesystem anzugeben, die eine vereinfachte Befestigung von Mess-Leitung ermöglichen.

### Zusammenfassung der Erfindung

Die Lösung der Aufgabe erfolgt durch einen Zellverbinder für ein Batteriesystem das mehrere Batteriezellen umfasst nach Anspruch 1.

Dadurch ist es möglich, eine relativ kleine Klemmverbindung herzustellen, wodurch Kosten und Gewicht, bei geringerem Bauraum, reduziert werden können. Es wird weiters eine bessere elektrisch leitende Verbindung zwischen den Polen der Zellen und der Messleitung ermöglicht. Ein weiterer Vorteil ist, dass die Mess-Leitungen lösbar mit den Zellverbindern verbunden sind.

Der Vorteil bei der Verwendung von Schneidklemmen ist, dass die Adern einer Mess-Leitung, mit Hilfe eines speziellen Werkzeugs, in die Schneidklemmen gepresst werden können, ohne die Mess-Leitung zuvor Abisolieren zu müssen. Aufgrund scharfer Kontakte in der metallischen Schneidklemme wird die Isolierung der Ader durchtrennt und eine gasdichte Verbindung hergestellt. Da es sich um eine löt-, schraub- und abisolierfreie Verbindungstechnik handelt, wird diese Technik oft als LSA- Technik bezeichnet.
Mit Hilfe dieser Technik lassen sich eine große Anzahl von Kabeln rasch und prozesssicher elektrisch und mechanisch kontaktieren, was besonders bei einem Batteriesystem mit einer hohen Anzahl an Batteriezellen zu einer großen Zeitersparnis führt.
Um eine gute Kontaktierung der Mess-Leitung in der Schneidklemme zu gewährleisten, ist es besonders vorteilhaft, dass die Schneidklemme und die Mess-Leitung aufeinander abgestimmt sind.

Weiterbildungen der Erfindung sind in den abhängigen Ansprüchen, der Beschreibung sowie den beigefügten Zeichnungen angegeben.

In einer erfinderischen Ausgestaltung erfolgt die Verbindung der Schneidklemme mit dem Zellverbinder durch beispielsweise Löten oder Ultraschallschweißen. Diese Technologien sind dem Fachmann hinlänglich bekannt und werden daher nicht beschrieben.

Alternativ kann die Schneidklemme durch Einpressen in den Zellverbinder mit diesen verbunden werden. Hierbei weist die Schneidklemme zumindest einen Fortsatz auf, welcher in zumindest eine entsprechend vorgefertigte Bohrung des Zellverbinders eingepresst wird.

Ein weiteres Verfahren ist das sogenannte "Schießen". Es handelt sich hierbei um eine Direktmontage, welche es als ein- oder mehrstufiges Befestigungsverfahren gibt. Beim einstufigen Verfahren wird ein Fortsatz der Schneidklemme ohne weitere Vorarbeiten (z.B. Bohren) direkt in den Zellverbinder eingetrieben. Dabei ist es von Vorteil, wenn die Schneidklemme, zumindest jedoch der Fortsatz, aus einem härteren Werkstoff als der Zellverbinder ausgebildet ist. Die Schneidklemme könnte beispielsweise einen spitzen Zapfen als Fortsatz aufweisen welcher beim "Schießen" durch den Zellverbinder getrieben wird.
Beim mehrstufigen Verfahren wird im Zellverbinder eine Bohrung mit geringer Tiefe erstellt. In diese Bohrung wird die Schneidklemme, wie beim einstufigen Verfahren, eingetrieben.
Beim Schießen handelt es sich um eine stoffschlüssige Kaltverformungskontaktierung.

Da beim Schießen und Einpressen die Schneidklemme zumindest einen Fortsatz aufweisen kann, welcher nach der Verbindung der Schneidklemme mit dem Zellverbinder durch diesen ragen kann, ist, bei der Verbindung des Zellverbinders mit einem Polanschluss einer Batteriezelle, darauf zu achten, dass eine ausreichend großer Abstand zwischen dem Fortsatz zu achten, dass eine ausreichend großer Abstand zwischen dem Fortsatz der Schneidklemme und der Oberfläche der Batteriezelle vorhanden ist, um eine Beschädigung der Oberfläche der Batteriezelle zu vermeiden bzw. eine ausreichend große elektrische Luft- / Kriech-Strecke zwischen den Bauteilen zu erreichen.
Dies kann durch eine entsprechende Höhe des Polanschlusses oder eine entsprechende geometrische Ausbildung des Zellverbinders erreicht werden.

Es kann natürlich im Rahmen der Erfindung jedes weitere dem Fachmann bekannte Verbindungsverfahren, zur geeigneten Verbindung der Schneidklemme mit dem Zellverbinder, beispielsweise Kleben, angewendet werden.
Die Verbindungsverfahren zur Herstellung der Verbindung der Schneidklemme mit dem Zellverbinder sind für den jeweiligen Anwendungsfall so angepasst, dass eine automatisierte Fertigung möglich ist.

Erfindungsgemäß besteht der Zellverbinder aus Aluminium bzw. einer Aluminiumlegierung .

Die Schneidklemme ist aus Nickel gefertigt, da Nickel günstige Eigenschaften hinsichtlich elektrischer Leitfähigkeit und Korrosionsbeständigkeit aufweist.

Die Schneidklemme besteht aus Kupfer und wird zumindest teilweise mit Nickel bzw. einer Nickellegierung beschichtet. Alternativ kann die Schneidklemme aus Kupfer mit einer Zinn-Beschichtung versehen sein.

Die Mess-Leitung ist zumeist eine Kupferleitung, da Kupfer ein guter Leiter ist. Die Herstellung einer solchen Leitung ist einfach und günstig.

Gemäß einer Ausführungsform der Erfindung wird eine Mess-Leitung in die Schneidklemme eingeführt.

Die Einführung der Mess-Leitung in die Schneidklemme kann hierbei vorzugsweise automatisiert erfolgen, wodurch eine schnelle, sichere und kostengünstige Montage realisiert werden kann.

Die Mess-Leitung ist zumindest abschnittsweise mit einer Isolationsschicht überzogen, um ungewollten Kontakt mit anderen elektrisch leitenden Bauteilen zu vermeiden.

In einer weiteren Ausführungsform ist die Mess-Leitung mit einer Elektronikeinheit mittels Schneidklemme oder Crimp verbunden. Die Schneidklemme kann hierbei auf der Mess-Leitung oder der Elektronikeinheit vorgesehen werden.

### Kurzbeschreibung der Zeichnungen

Die Erfindung wird im Folgenden beispielhaft unter Bezugnahme auf die Zeichnungen beschrieben.
- Fig. 1: zeigt eine Draufsicht eines Batteriesystems aus mehreren Zellen bestehend, mit erfindungsgemäßen Zellverbindern.
- Fig. 2: zeigt eine Detailansicht gemäß Fig. 1 von oben.
- Fig. 3: zeigt eine Anordnung einer Schneidklemme auf einem Zellverbinder.
- Fig. 4; 5; 6: zeigen Verbindungsverfahren zur Anbringung einer Schneidklemme auf einem Zellverbinder.

### Detaillierte Beschreibung der Erfindung

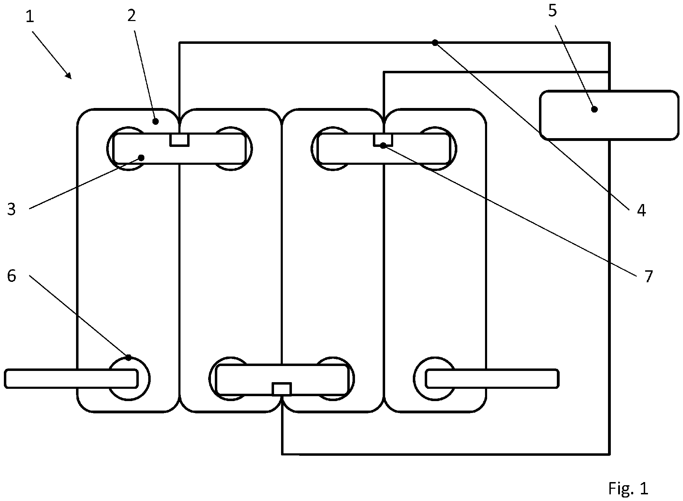

In Fig. 1 wird schematisch eine erfindungsgemäße Anordnung eines Batteriesystems 1 bestehend aus mehreren Batteriezellen 2, welche durch Zellverbinder 3 miteinander in Reihe geschalten sind, dargestellt. Solche Batteriesysteme sind beispielsweise in Elektrofahrzeugen und Hybridfahrzeugen in Verwendung. Zum Spannungsabgriff der Batteriezellen 2 werden Mess-Leitungen 4 eingesetzt, welche an einem Ende mit einer Elektronikeinheit 5 und am anderen Ende mit einer Schneidklemme 7 verbunden sind. Die Elektronikeinheit 5 wandelt die von der Messleitung 4 übertragenen elektrischen Spannungen in digitale Signale um. Diese Signale werden in weiterer Folge zur Steuerung des Batteriesystems herangezogen. Die Schneidklemme 7 ist an einem Zellverbinder 3 angeordnet. Der Zellverbinder 3 ist mit einem positiven Pol 6 einer Batteriezelle 2 und einem negativen Pol 6 einer weiteren, benachbarten, Batteriezelle 2 elektrisch verbunden.

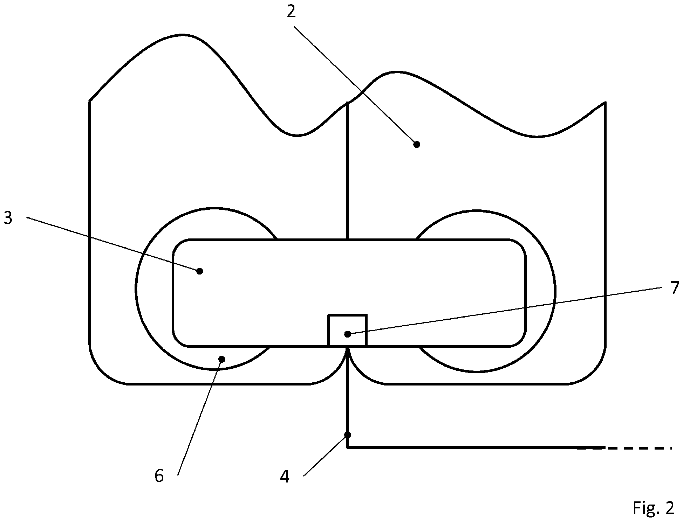

Fig. 2 zeigt eine Detailansicht von Fig. 1, wobei auf dem Zellverbinder 3 die Schneidklemme 7 schematisch dargestellt ist. Die Mess-Leitung 4 ist mit der Schneidklemme 7 elektrisch leitfähig verbunden. Der Zellverbinder 3 ist mit einem positiven Pol 6 einer Batteriezelle 2 und einem negativen Pol 6 einer angrenzenden Batteriezelle 2 elektrisch leitfähig verbunden, beispielsweise durch eine stoffschlüssige Verbindung. Die Messleitung 4 überträgt die elektrische Spannung die am Zellverbinder 3 anliegt an die Elektronikeinheit 5 (nicht dargestellt).

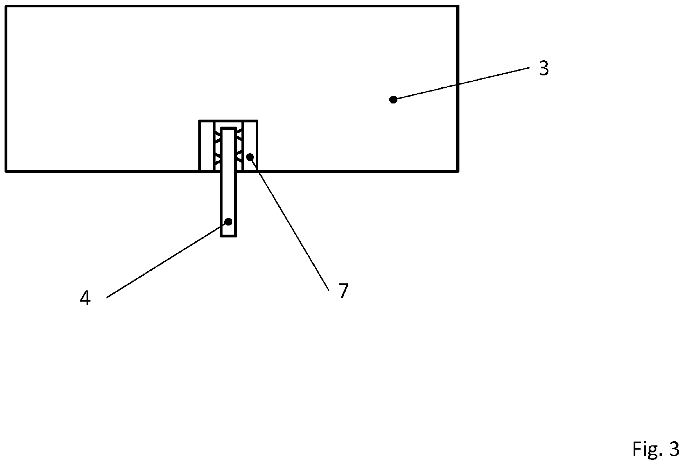

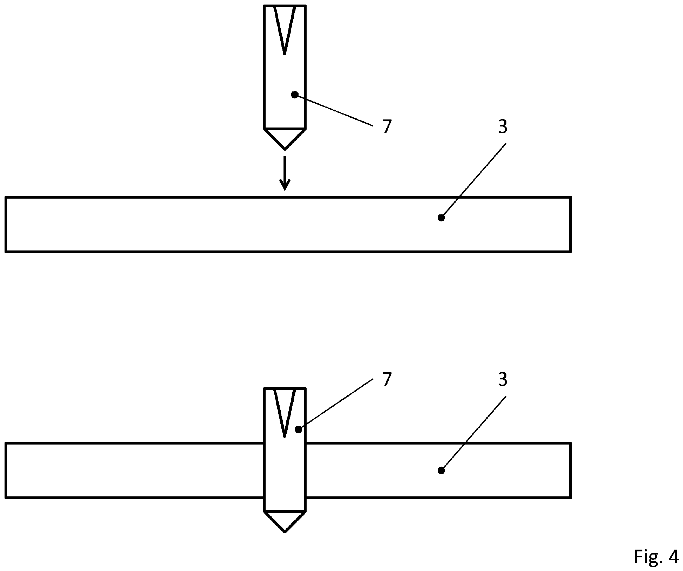

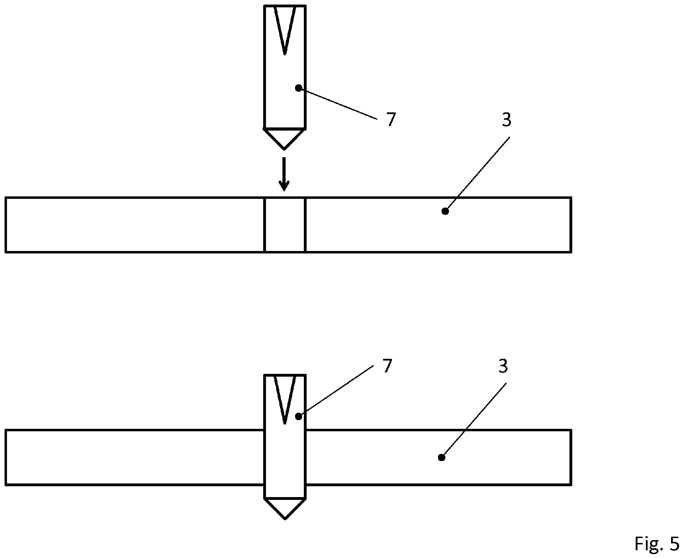

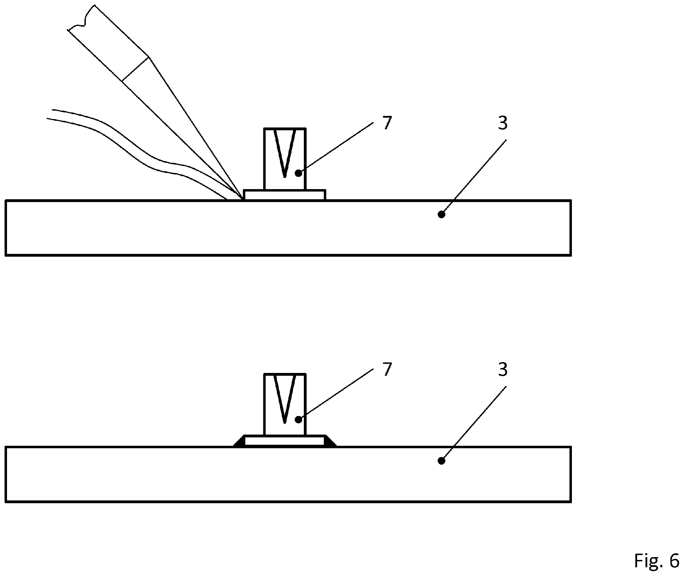

In Fig. 3 wird schematisch die Anordnung der Schneidklemme 7 am Zellverbinder 3 dargestellt. Die Schneidklemme 7 ist mit dem Zellverbinder 3 verbunden. Die Mess-Leitung 4 ist mit der Schneidklemme 7 verbunden. Die Schneidklemme 7 kann mittels mehrerer Verfahren mit dem Zellverbinder 3 verbunden werden. Fig. 4 zeigt schematisch ein Verfahren, bei dem die Schneidklemme 7 durch sogenanntes "Schießen" mit dem Zellverbinder 3 verbunden wird. Bei diesem Verfahren ist die Schneidklemme 7 vorteilhaft aus einem härteren Werkstoff als der Zellverbinder 3 ausgeführt. Der Zellverbinder 3 kann alternativ entsprechende Bohrungen aufweisen. In Fig. 5 wird ein Verfahren schematisch dargestellt, bei dem die Schneidklemme 7 in den Zellverbinder 3 eingepresst wird. Die Schneidklemme 7 kann einen oder mehrere Fortsätze aufweisen, welche in entsprechende Bohrungen des Zellverbinders 3 einpressbar sind. Ein weiteres Verfahren wird in Fig. 6 schematisch dargestellt. Bei diesem Verfahren wird die Schneidklemme 7 durch Löten mit dem Zellverbinder 3 verbunden. Es kann natürlich auch jedes geeignetes Klebe- oder Schweißverfahren angewendet werden.

### Bezugszeichenliste

- 1: Batteriesystem
- 2: Batteriezelle
- 3: Zellverbinder
- 4: Mess-Leitung
- 5: Elektronikeinheit
- 6: Pol
- 7: Schneidklemme

## Patentansprüche

1. Zellverbinder (3) für ein Batteriesystem (1) das mehrere Batteriezellen (2) umfasst, wobei durch den Zellverbinder (3) ein Pol (6) einer Batteriezelle (2) mit einem Pol (6) einer angrenzenden Batteriezelle (2) elektrisch leitend verbindbar ist,
**dadurch gekennzeichnet dass** der Zellverbinder (3) aus Aluminium bzw. eine Aluminiumlegierung besteht, und wobei am Zellverbinder (3) zum Abgriff der elektrischen Spannung zumindest eine Schneidklemme (7) vorgesehen ist, wobei die Schneidklemme (7) aus Kupfer oder Nickel besteht oder zumindest teilweise verzinnt oder vernickelt ist.

2. Zellverbinder (3) nach Anspruch 1,
**dadurch gekennzeichnet, dass** die Schneidklemme (7) auf den Zellverbinder (3) gelötet oder mit dem Zellverbinder (3) ultraschallgeschweißt oder in den Zellverbinder (3) eingepresst oder eingeschossen ist.

3. Batteriesystem (1) mit mehreren Batteriezellen (2) mit Zellverbindern (3) nach Anspruch 1,
**dadurch gekennzeichnet, dass** in die Schneidklemme (7) eine Mess-Leitung (4) einführbar ist.

4. Batteriesystem (1) mit mehreren Batteriezellen (2) mit Zellverbindern (3) nach Anspruch 3,
**dadurch gekennzeichnet, dass** die Mess-Leitung (4) aus Kupfer besteht und mit einer elektrischen Isolationsschicht überzogen ist.

5. Batteriesystem (1) mit mehreren Batteriezellen (2) mit Zellverbindern (3) nach Anspruch 3,
**dadurch gekennzeichnet, dass** die Mess-Leitung (4) mit einer Elektronikeinheit (5) mittels einer weiteren Schneidklemme verbindbar ist.

## Claims

1. Cell connector (3) for a battery system (1) which comprises a plurality of battery cells (2), a pole (6) of a battery cell (2) being electrically conductively connectable by the cell connector (3) to a pole (6) of an adjacent battery cell (2),
**characterised in that** the cell connector (3) is composed of aluminium or an aluminium alloy, and at least one insulation displacement termination (7) being provided on the cell connector (3) for tapping the electric voltage, the insulation displacement termination (7) being composed of copper or nickel or at least partially tin-plated or nickel-plated.

2. Cell connector (3) according to claim 1,
**characterised in that** the insulation displacement termination (7) is soldered onto the cell connector (3) or ultrasonically welded to the cell connector (3) or pressed into or shot into the cell connector (3).

3. Battery system (1) having a plurality of battery cells (2) with cell connectors (3) according to claim 1, **characterised in that** a measuring line (4) is insertable into the insulation displacement termination (7).

4. Battery system (1) having a plurality of battery cells (2) with cell connectors (3) according to claim 3,
**characterised in that** the measuring line (4) is composed of copper and is coated with an electrical insulation layer.

5. Battery system (1) having a plurality of battery cells (2) with cell connectors (3) according to claim 3,
**characterised in that** the measuring line (4) is connectable to an electronic unit (5) by means of a further insulation displacement termination.

## Revendications

1. Connecteur de cellules (3) pour un système de batterie (1) comprenant plusieurs cellules de batterie (2), un pôle (6) d'une cellule de batterie (2) pouvant être connecté à un pôle (6) d'une cellule de batterie (2) adjacente de manière électriquement conductrice par le connecteur de cellules (3),
**caractérisé en ce que**
ledit connecteur de cellules (3) est en aluminium ou en un alliage d'aluminium, et **en ce qu'**au moins une borne auto-dénudante (7) est prévue sur le connecteur de cellules (3) pour la prise de la tension électrique, la borne auto-dénudante (7) étant en cuivre ou en nickel ou étant au moins partiellement étamée ou nickelée.

2. Connecteur de cellules (3) selon la revendication 1,
**caractérisé en ce que**
la borne auto-dénudante (7) est brasée sur le connecteur de cellules (3) ou soudée par ultrasons sur le connecteur de cellules (3) ou serrée ou sertie dans le connecteur de cellules (3).

3. Système de batterie (1) avec plusieurs cellules de batterie (2) pourvues de connecteurs de cellules (3) selon la revendication 1,
**caractérisé en ce qu'**
une ligne de mesure (4) est insérable dans la borne auto-dénudante (7).

4. Système de batterie (1) avec plusieurs cellules de batterie (2) pourvues de connecteurs de cellules (3) selon la revendication 3,
**caractérisé en ce que**
la ligne de mesure (4) est en cuivre et est revêtue d'une couche d'isolation électrique.

5. Système de batterie (1) avec plusieurs cellules de batterie (2) pourvues de connecteurs de cellules (3) selon la revendication 3,
**caractérisé en ce que**
la ligne de mesure (4) peut être reliée à une unité électronique (5) au moyen d'une autre borne auto-dénudante.
